# EUROPEAN PATENT SPECIFICATION

(11) **EP 0 249 371 B1**
(45) Date of publication and mention of the grant of the patent: **04.09.1996**
(21) Application number: 87304812.8
(22) Date of filing: 01.06.1987
(51) Int. Cl.: H01L 29/201, H01L 29/80

(54) **Semiconductor device including two compound semiconductors, and method of manufacturing such a device**
Halbleiteranordnung mit zwei Verbindungshalbleitern und Verfahren zu ihrer Herstellung
Dispositif semi-conducteur comprenant deux semi-conducteurs composés et sa méthode de fabrication

(30) Priority: 02.06.1986 JP 125736/86
(43) Date of publication of application: 16.12.1987
(73) Proprietor: HITACHI, LTD., Chiyoda-ku, Tokyo 101 (JP)
(72) Inventor: Kuroda, Takao, Koganei-shi Tokyo (JP); Miyazaki, Takao, Hachioji-shi Tokyo (JP); Watanabe, Akiyoshi, Koganei-shi Tokyo (JP); Matsumura, Hiroyoshi, Iruma-gun Saita-ma-ken (JP)
(74) Representative: Calderbank, Thomas Roger

(56) References cited:
- APPLIED PHYSICS LETTERS, vol. 48, no. 16, April 1986, pages 1080-1082, American Institute of Physics, Woodbury, New York, US; T. HENDERSON et al.: "dc and microwave characteristics of a high-current double interface GaAs/InGaAs/AlGaAs pseudomorphic modulation-doped field-effect transistor"
- IEEE ELECTRON DEVICE LETTERS, vol. EDL-7, no. 5, May 1986, pages 288-290, IEEE, New York, US; T.S. HENDERSON et al.: "Determination of Carrier saturation velocity in high-performance InyGa1-yAs/AlxGa1-xAs modulation-doped field-effect transistors (0 y 0.2)
- IEEE ELECTRON DEVICE LETTERS, vol. EDL-6, no. 1, January 1985, pages 20-21, IEEE, New York, US; C.Y. CHEN et al.: "A new Ga0.47In0.53As field-effect transistor with a lattice-mismatched GaAs gate for high-speed circuits"
- INST. PHYS. CONF. SER., no. 74, chapter 5, paper presented at int. symp. GaAs and related compounds, Biarritz, 1984, pages 321-326, Adam Hilger Ltd; H. LEE et al.: "Optimized GaAs/(Al,Ga)As modulation doped heterostructures"
- IEEE Journal of Quantum Electronics, vol. QE-11, no. 7, 1975, pp. 562-568 ; P.A. Kirkby : "Dislocation Pinning in GaAs by the Deliberate Introduction of Impurities"
- JOURNAL OF APPLIED PHYSICS, vol. 47, no. 7, 1976, pp. 3374-3376 ; Y. SEKI et al.: "Impurity effect on the growth of dislocation-free InP single crystals"
- APPLIED PHYSICS LETTERS, vol. 52, no. 7, 1988, pp. 543-545 ; M. SHINOHARA et al.: "Dislocation-free GaAs epitaxial growth with the use of modulation-doped AIAs-GaAs superlattice buffer layers"
- JOURNAL OF APPLIED PHYSICS, vol. 62, no. 7, 1988, pp. 543-545 ; I. YONENAGA et al.: "Effects of In impurity on the dynamic behavior of dislocations in GaAs"

## Description

The present invention relates to a semiconductor device including two compound semiconductors, and a method of manufacturing such a device.

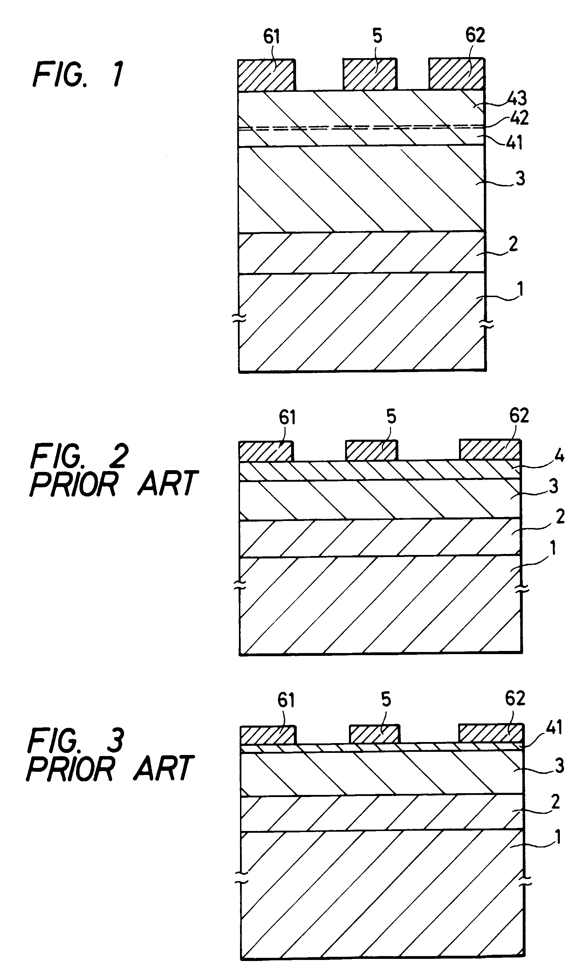

InₓGa₁₋ₓAs_{y}P_{1-y} mixed crystals which are lattice-matched to InP substrates, especially (InGa)As ternary mixed crystals, exhibit high mobilities such as e.g. 8000 cm²/V-sec at room temperature. Therefore, such mixed crystals have been considered as materials for forming high-speed FETs. Since a suitable Schottky junction cannot be formed, a method has been employed wherein a semiconductor device is formed by growing lattice-matched (InAl)As on the surface of the mixed crystals so as to form a Schottky junction on the grown layer (refer to H. Ohno et al: IEEE, Electron Device Lett. Vol. EDL-1, p.154, 1980). Such a semiconductor device is shown in Fig. 2 of the accompanying drawings. The device has a buffer layer 2 on a substrate, a compound semiconductor layer 3 on the buffer layer 2, and a cap layer 4 of lattice matched InAlAs on the compound semiconductor layer 3. Source and drain electrodes 61,62 and a gate electrode 5 are formed on the cap layer 4.

This material InAlAs, however, has two disadvantages. It is very prone to oxidation because the mol ratio of AlAs is 0.5, and also it exhibits a Schottky barrier of 0.6 V which is not very high.

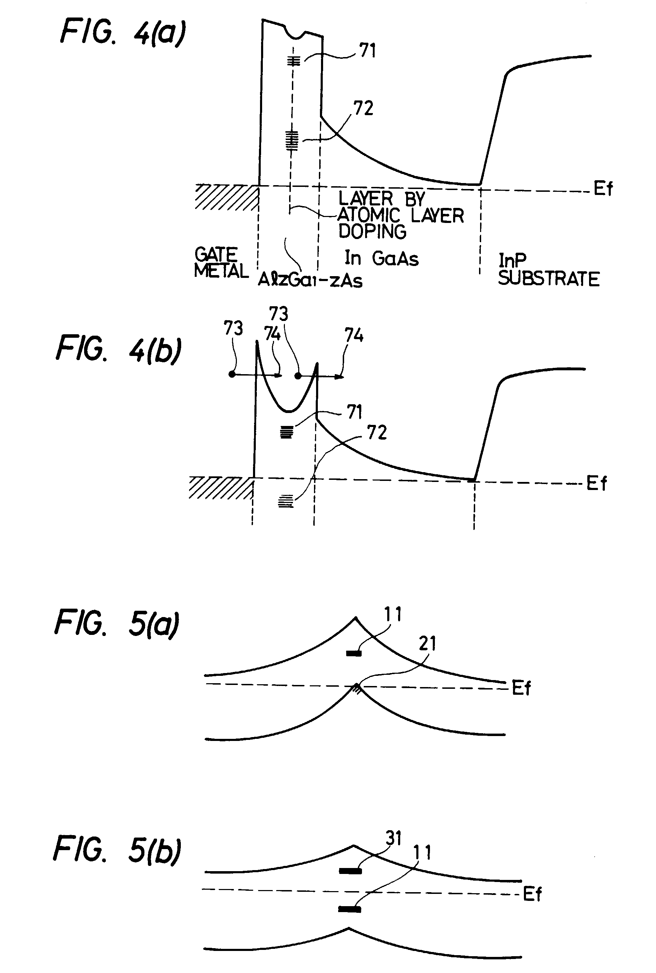

A FET has recently been fabricated experimentally which, as shown in Fig. 3 of the accompanying drawings, has a thin film of GaAs (41) having a lattice constant greatly different from that of an InP substrate (1) is grown on InGaAs layer (3). The device shown in Fig. 3 is otherwise similar to that shown in Fig. 2 and corresponding parts are indicated by the same reference numerals. In this device, however, a thick film of or above approximately 40 nm cannot afford a good surface because of lattice mismatching which is as much as 4%. Moreover, since a very high density of dislocation networks exist at the boundary, the leakage current flows through the dislocations, and characteristics satisfactory for the gate electrode of a FET has not been obtained (refer to C.Y. Chen et al: Appl. Phys. Lett., Vol, 46 (1985), p. 1145, and C.Y. Chen et al: IEEE, Electron Device Lett., Vol. EDL-6 (1985), p. 20).

The stabilities of such devices and the characteristics thereof are not considered in the prior art however.

The present invention seeks to solve, or at least reduce, the problems of the prior art devices discussed above.

In an article entitled "Optimized GaAs/(AlGa)As modulation doped heterostructure" in Inst. Phy. Conf. Ser. No: 74; chapter 5, pp. 321-326, a semiconductor device is disclosed having a first and a second compound semiconductor regions with a different lattice constants the second compound semiconductor region having at least two semiconductor layers and one impurity layer between these two semiconductor layers. The disclosure of this document corresponds to the pre-characterising part of claim 1 of this application.

According to one aspect of the present invention, there is provided a semiconductor device having a first compound semiconductor region (3) with a first lattice constant, and a second compound semiconductor region (41,42,43) on the first compound semiconductor region (3), with a second lattice constant different from the first lattice constant;
the second compound semiconductor region (41,42,43) having at least two second compound semiconductor layers (41,43) and there being at least one impurity layer (42) between adjacent second compound semiconductor layers (41,43) of the second compound semiconductor region (41,42,43) respectively;
characterized in that:
the first and second lattice constants of the first and second compound semiconductor regions (3; 41,42,43) differ such that the lattice mismatch thereof causes dislocation networks in the second compound semiconductor layers (41) neighbouring the first compound semiconductor region (3);
in that the at least one impurity layer (42) has impurities which are selectively adsorbed or gettered around the dislocations and of such type that they neutralize the resulting charges of the dislocation cores; and
in that the impurity concentration in the at least one impurity layer (42) is adapted to the thickness of the second compound semiconductor layers (41,43) such that tunnel currents through the second semiconductor region (41,42,43) are avoided.

The present invention also provides a semiconductor device which has advantages in the fabrication thereof, particularly in that it becomes possible to reduce a device with a very small number of defects.

A semiconductor device according to the present invention may operate in a stable manner and may have significantly enhanced characteristics.

According to another aspect of the present invention, there is provided a method of manufacturing a semiconductor device comprising forming a first semiconductor layer (41) on a first compound semiconductor region (3) which has a first lattice constant, the first semiconductor layer (41) being a second compound semiconductor with a second lattice constant different from the first lattice constant; forming at least one impurity layer (42) on the first compound semiconductor layer (41); and
forming a second semiconductor layer (43) of the second compound semiconductor over the at least one impurity layer (42);
characterized in that:
the first and second lattice constants differ such that the mismatch thereof causes dislocation networks in the first semiconductor layer (4); and the at least one impurity layer (42) has impurities which are selectively adsorbed or gettered around the dislocations and of such type that they neutralize the resulting charges of the dislocation cores; and in that the impurity concentration in the at least one impurity layer (42) is adapted to the thickness of the second compound semiconductor layers (41,43) such that tunnel currents through the second semiconductor region (41,42,43) are avoided.

An embodiment of the present invention will now be described in detail, by way of example, with reference to the accompanying drawings, in which:
Fig. 1 is a diagram showing an embodiment of an FET according to the present invention;
Fig. 2 is a diagram showing a prior art FET in which a cap layer is made of InAlAs, and has already been discussed;
Fig. 3 is a diagram showing a prior art FET, in which a strained cap layer is made of GaAs, and has already been discussed;
Fig. 4(a) is a diagram showing an energy band structure of a device with atomic layer doping to an appropriate amount of impurity, while Fig. 4(b) is a diagram of an energy band structure for explaining the increase of a leakage current when atomic layer doping with an impurity element is excessive.
Figs. 5(a) and 5(b) are diagrams for explaining the effect of the passivation of dislocations.

The structure of a semiconductor device according to an embodiment of the present invention will be described with reference to Fig. 1. Parts of the device corresponding to those of Fig. 2 are indicated by the same reference numerals. In the example of Fig. 1, first GaAs 41 is grown on an InGaAs layer 3, the GaAs 41 being grown to a thickness of 5 to 30 nm, before growth is suspended. A donor impurity 42, such as Si, is adsorbed on the grown surface. Thereafter, the growth of further GaAs 43 is restarted, and that growth is stopped at a thickness of at most about 60 nm, being the limit at which the surface morphology of a film deteriorates. Preferably the thickness is about 40 nm. With this structure, there is lattice mismatching between InGaAs and GaAs, and therefore a high density of dislocation networks appear within the first GaAs layer 41 with a thickness of 5 to 30 nm. Impurities such as Si are adsorbed or gettered selectively around dislocations, and the donors neutralize the charge of dislocation cores which normally act as acceptors. Thus, local bending of energy bands within the grown layer is remedied, and this causes a decrease in the leakage current.

The principles of the above behaviour will now be discussed with reference to Figs. 5(a) and 5(b). These figures illustrate the band gaps of GaAs when dislocations have developed.

Fig. 5(a) depicts the bending of energy band of GaAs due to a defect caused by a dislocation, so that current tends to flow along the dislocation, i.e. perpendicularly to the plane of the drawing. In Fig. 5(a), there is shown a deep acceptor level 11 induced by a defect such as a dislocation, and holes 21 accumulated by the bending of the energy band in the vicinity of the dislocation. The broken line in the figure denotes the Fermi level E_{f}. In this manner, defects caused by dislocation or the like distort the energy band of GaAs, with the result that a leakage current develops.

Fig. 5(b) depicts the band gap of GaAs in the semiconductor device according to the present invention. As in the case of Fig. 5(a), there is shown a deep acceptor level 11 caused by a defect such as a dislocation. In Fig. 5(b), however, the energy band of GaAs is not distorted so much as in Fig. 5(a). The reason for this is that the GaAs layer is doped with an impurity such as Si. Therefore a donor level 31 based on the doping is formed. To form the donor level 31, the growth of GaAs is suspended, and an impurity such as Si is adsorbed to the dislocation by doping, thereby causing charge neutralization and the suppression of bending of the band. In this example, therefore, holes are not accumulated, and the leakage current decreases significantly.

Although, in the above description, the only donor impurity discussed is Si, it is also possible to use another group-IV element, for example, Ge or C. Also, when it is required that the impurity be an acceptor, a group-VI element such as S, Se or Te can be used.

The only grown film, discussed above is of GaAs (the Schottky barrier height of which is about 0.8 eV), but Al_{z}Ga_{1-z}As which has a higher Schottky barrier may alternatively be used. With Al_{z}Ga_{1-z}As, when 0 < z < 0.5, the barrier height can be increased continuously from 0.8 eV to 1.2 eV. When the mol ratio of AlAs exceeds 0.7, there is a risk of surface oxidation, as in the case of InAlAs in Fig. 2. Therefore, a mixing ratio of approximately 0 < z < 0.5 is more desirable when considering processes for the prevention of oxidation, etc. and also when considering the reliability of the device.

It is also possible to use a material with an even larger difference of lattice constants, for example, GaAsP, InGaP or InAlP to form the grown film.

A method of doping in which, after the suspension of the growth of the film, impurity is adsorbed or ion-implanted into the grown surface, and then the impurity is buried by regrowth, shall be referred to as "atomic layer doping".

In the present invention, it is important that the method of atomic layer doping does not act merely as a doping method, but that it works as passivation for inactivating the high-density dislocation networks existing in the compound semiconductor film. Suspension of the growth of that film may only be performed once, but repetition thereof with growth of each 10 nm of film is more effective. However, when the impurity concentration becomes too high, the apparent height of the Schottky barrier decreases due to the doping effect, and hence, it is more advantageous to form the thickest possible undoped region adjacent the Schottky electrode.

The principle of this will now be described with reference to Figs. 4(a) and 4(b). These figures are diagrams showing the increase of the leakage current when the impurity doping is excessive.

Fig. 4(a) depicts the energy band structure of a semiconductor device when an appropriate amount of impurity has been introduced by atomic layer doping. In Fig. 4(a), there is shown a deep level 72 caused by a dislocation or similar defect. As illustrated in Figs. 5(a) and 5(b), impurities are introduced by doping in order to reduce the distortion of the band due to the deep level. Region 71 is the donor level of the impurity. In this example, the impurity doping does not affect significantly the height of the Schottky barrier and poses no problem.

On the other hand, Fig. 4(b) depicts the energy band structure when the amount of the atomic layer doping with impurity is excessive. Under the influence of a donor level 71 caused by the impurity, the energy band of a strained cap layer is bent downwards greatly, and tunnel currents 74 due to carriers (electrons) 73 increase, causing leakage current. This is because the shape of the potential becomes triangular, so the thickness of the barrier, in effect, decreases. To avoid this problem, it is more preferable that the undoped region is as thick as possible adjacent the Schottky electrode.

Now, examples of the present invention will be described with reference to Fig. 1. A semi-insulating Fe-doped InP substrate 1 was etched with a mixture of Br-methanol and sulphuric acid : hydrogen peroxide : water to a ratio of 4 : 1 : 1 (volumetric ratio). Thereafter, using a metal-organic chemical vapour deposition (MOCVD) method at a growth temperature of 640 °C, an undoped InP buffer layer 2 was grown to a thickness of about 300 nm, an n-doped InGaAs layer 3 (the dopant concentration being of the order of 1 x 10¹⁷ cm⁻³) was grown to a thickness of 150 nm, and undoped GaAs 41 was grown to a thickness of 10 nm. The growth of the GaAs was then suspended. With arsine (AsH₃) flowing, Si was supplied in the form of disilane (Si₂H₆) and was caused to flow at such a rate that an Si layer 42 with, at most, a uniatomic thickness was adsorbed to the surface of the undoped GaAs 41. Subsequently, a GaAs layer 43 was grown again until the whole of the GaAs material was about 40 nm thick. Thereafter, using conventional processes for fabricating an FET, a source electrode 61 and a drain electrode 62 were formed by ohmic contact electrodes of AnGe/Ni/An, and a gate electrode 5 was formed by a Schottky electrode of Al/Ti. The static characteristics of the FET thus manufactured were measured. For the sake of comparison n-GaAs (the dopant concentration being of the order of 1 x 10¹⁷ cm⁻³ and being about 150 nm thick) was grown on semi-insulating GaAs by MOCVD, and an FET was manufactured by the same processes. It was found that the leakage current perforamce of the gate of both the FETs was substantially the same. Thus an InGaAs-based MESFET equivalent to a MESFET of GaAs can be produced according to the method of the present invention.

The growth was carried out with the growth temperature lowered from 640 °C to 600 °C and 550 °C, to form devices of the structure in Fig. 1, and the characteristics of the devices were compared. It was found that, at the lower growth temperature, the FET was improved, as the leakage current of the gate was reduced.

A sample device grown as in Fig. 1 was produced by molecular beam epitaxy (MBE) and favourable FET characteristics with a reduced leakage current were attained. In this case, even when InAlAs lattice-matched with InP was used to form the buffer layer 2, instead of InP, similar favourable characteristics were attained.

Moreover, similar characteristics were obtained even when a large number of semiconductor layers each consisting of thin layers 41,42 and 43 were stacked one on the other.

Furthermore, when the GaAs was replaced with Al_{z}Ga₁₋ _{z}As, with 0 < z ≤ 0.5, a decrease in the leakage current corresponding to an increase in the Schottky barrier height was observed.

The above discussion concentrated on the formation of the Schottky junction for InGaAs. In general, however, the method of the present invention is similarly applicable to any situation where a thin layer of a material of higher Schottky barrier, such as GaAs, is grown on a material of lower Schottky barrier, for example, InP, InAs, or InSb(InGa)(AsP).

Also when considering an FET made of GaAs, significant merits such as reduction in the gate current are attained when a further thin layer of a material of higher Schottky barrier such as InGaP or GaAsP is further grown on the GaAs layer itself.

Ion implantation of Si was also effective as a method of achieving impurity adsorption when the growth of the compound semiconductor was by MBE. On this occasion, growth was suspended, the ions were implanted to shallow depth several tens of nanometres in the surface of the grown layer, and the growth was thereafter restarted.

According to the examples stated above, the operating layer of a device and a material for forming a Schottky junction need not always be lattice-matched. In consequence, the combination of optimum materials can be used in each case, and there may be enhancement in performance and expansion in the versatility of design of an FET and other devices employing Schottky junctions. In addition, the idea that defects such as dislocations generated at a high density in a hetero-boundary are passivated by the electron layer doping based on impurity adsorption is important from the viewpoint of improving the reliability of the device.

It is to be understood that the embodiments of the present invention discussed in the above detailed description are intended to illustrate the technical content of the invention, and the present invention shall not be construed as being limited to such embodiments only.

## Claims

1. A semiconductor device having a first compound semiconductor region (3) with a first lattice constant, and a second compound semiconductor region (41,42,43) on the first compound semiconductor region (3), with a second lattice constant different from the first lattice constant;
the second compound semiconductor region (41,42,43) having at least two second compound semiconductor layers (41,43) and there being at least one impurity layer (42) between adjacent second compound semiconductor layers (41,43) of the second compound semiconductor region (41,42,43) respectively;
characterised in that:
the first and second lattice constants of the first and second compound semiconductor regions (3;41,42,43) differ such that the lattice mismatch thereof causes dislocation networks in the second compound semiconductor layers (41) neighbouring the first compound semiconductor region (3); in that the at least one impurity layers (42) has impurities which are selectively adsorbed or gettered around the dislocations and of such type that they neutralize the resulting charges of the dislocation cores; and in that the impurity concentration in the at least one impurity layer (42) is adapted to the thickness of the second compound semiconductor layers (41,43) such that tunnel currents through the second semiconductor region (41,42,43) are avoided.

2. A semiconductor device according to claim 1, wherein the impurities are donors.

3. A semiconductor device according to claim 1 or claim 2 wherein the impurity layer (42) contains Si as an impurity.

4. A semiconductor device according to any one of the preceding claim wherein the second compound semiconductor layer (43) of the second compound semiconductor region furthest from the first compound semiconductor (3) has a thickness not more than 60nm, and the or each other second compound semiconductor layer has a thickness between 5 and 30nm.

5. A semiconductor device according to any one of the preceding claims, wherein the first compound semiconductor region (3) is (InGa)As.

6. A semiconductor device according to any one of the preceding claims wherein the second compound semiconductor region is GaAs.

7. A semiconductor device according to any one of claims 1 to 5 wherein said second compound semiconductor region is Ga_{1-Z}Al_{Z}As (0<Z≤0.7).

8. A semiconductor device according to any one of claims 1 to 4 wherein the first compound semiconductor region is a quarternary mixed crystal expressed by (In_{X}Ga_{1-X}) (As_{Y}P_{1-Y}) with 0<X, Y<1; and the second compound semiconductor is a tertiary mixed crystal expressed by Ga_{1-Z}Al_{Z}As with 0<Z≤0.7.

9. A method of manufacturing a semiconductor device comprising forming a fist semiconductor layer (41) on a first compound semiconductor region (3) which has a first lattice constant, the first semiconductor layer (41) being a second compound semiconductor with a second lattice constant different from the first lattice constant; forming at least one impurity layer (42) on the first compound semiconductor layer (41); and
forming a second semiconductor layer (43) of the second compound semiconductor over the at least one impurity layer (42);
characterised in that:
the first and second lattice constants differ such that the mismatch thereof causes dislocation networks in the first semiconductor layer (4); and the at least one impurity layer (42) has impurities which are selectively adsorbed or gettered around the dislocations and of such type that they neutralize the resulting charges of the dislocation cores; and in that the impurity concentration in the at least one impurity layer (42) is adapted to the thickness of the second compound semiconductor layers (41,43) such that tunnel currents through the second semiconductor region (41,42,43) are avoided.

10. A method according to claim 9, wherein the first semiconductor layer (41) and the second semiconductor layer (43) are formed by crystal growth.

## Patentansprüche

1. Halbleiteranordnung mit einem ersten Verbindungshalbleiter-Bereich (3) mit einer ersten Gitterkonstante und einem zweiten Verbindungshalbleiter-Bereich (41, 42, 43) auf dem ersten Verbindungshalbleiter-Bereich (3) mit einer zweiten Gitterkonstante, die von der ersten Gitterkonstanten verschieden ist;
- wobei der zweite Verbindungshalbleiter-Bereich (41, 42, 43) mindestens zwei zweite Verbindungshalbleiter-Schichten (41, 43) aufweist und mindestens eine Fremdstoffschicht (42) zwischen jeweils benachbarten zweiten Verbindungshalbleiter-Schichten (41, 43) des zweiten Verbindungshalbleiter-Bereichs (41, 42, 43) liegt;
**dadurch gekennzeichnet**, daß:
- die erste und zweite Gitterkonstante des ersten und zweiten Verbindungshalbleiter-Bereichs (3; 41, 42, 43) in solcher Weise voneinander verschieden sind, daß die Gitterfehlanpassung derselben Versetzungsnetzwerke in den zweiten Verbindungshalbleiter-Schichten (41) benachbart zum ersten Verbindungshalbleiter-Bereich (3) hervorruft; daß die mindestens eine Fremdstoffschicht (42) Fremdstoffe aufweist, die selektiv um die Versetzungen adsorbiert oder gegettert werden und von solchem Typ sind, daß sie die sich ergebenden Ladungen der Versetzungskerne neutralisieren; und daß die Fremdstoffkonzentration in der mindestens einen Fremdstoffschicht (42) an die Dicke der zweiten Verbindungshalbleiter-Schichten (41, 43) derart angepaßt ist, daß Tunnelströme durch den zweiten Halbleiterbereich (41, 42, 43) vermieden sind.

2. Halbleiteranordnung nach Anspruch 1, bei der die Fremdstoffe Donatoren sind.

3. Halbleiteranordnung nach Anspruch 1 oder Anspruch 2, bei der die Fremdstoffschicht (42) Si als Fremdstoff enthält.

4. Halbleiteranordnung nach einem der vorstehenden Ansprüche, bei der die zweite Verbindungshalbleiter-Schicht (43) des zweiten Verbindungshalbleiter-Bereichs, die am weitesten vom ersten Verbindungshalbleiter (3) weg liegt, eine Dicke von nicht mehr als 60 nm aufweist, und daß die andere oder jede andere zweite Verbindungshalbleiter-Schicht eine Dicke zwischen 5 und 30 nm aufweist.

5. Halbleiteranordnung nach einem der vorstehenden Ansprüche, bei der der erste Verbindungshalbleiter-Bereich (3) aus (InGa)As besteht.

6. Halbleiteranordnung nach einem der vorstehenden Ansprüche, bei der der zweite Verbindungshalbleiter-Bereich aus GaAs besteht.

7. Halbleiteranordnung nach einem der Ansprüche 1 bis 5, bei der der zweite Verbindungshalbleiter-Bereich aus Ga_{1-Z}Al_{Z}As (0 < Z ≤ 0,7) besteht.

8. Halbleiteranordnung nach einem der Ansprüche 1 bis 4, bei der der erste Verbindungshalbleiter-Bereich aus einem quartären Mischkristall gemäß (In_{X}Ga_{1-X}) (As_{Y}P_{1-Y}), mit 0 < X, Y < 1, besteht und der zweite Verbindungshalbleiter ein tertiärer Mischkristall, gemäß Ga_{1-Z}Al_{Z}As, mit 0 < Z ≤ 0,7, ist.

9. Verfahren zum Herstellen einer Halbleiteranordnung, umfassend das Folgende: Herstellen einer ersten Halbleiterschicht (41) auf einem ersten Verbindungshalbleiter-Bereich (3) mit einer ersten Gitterkonstante, wobei die erste Halbleiterschicht (41) ein zweiter Verbindungshalbleiter mit einer zweiten Gitterkonstante, verschieden von der ersten Gitterkonstante, ist; Herstellen mindestens einer Fremdstoffschicht (42) auf der ersten Verbindungshalbleiter-Schicht (41); und Herstellen einer zweiten Halbleiterschicht (43) auf dem zweiten Verbindungshalbleiter über der mindestens einen Fremdstoffschicht (42);
**dadurch gekennzeichnet**, daß
- die erste und zweite Gitterkonstante in solcher Weise voneinander verschieden sind, daß ihre Fehlanpassung Versetzungsnetzwerke in der ersten Halbleiterschicht (4) hervorruft; und die mindestens eine Fremdstoffschicht (42) Fremdstoffe aufweist, die um die Versetzungen herum selektiv adsorbiert oder gegettert werden und von solchem Typ sind, daß sie die sich ergebenden Ladungen der Versetzungskerne neutralisieren; und daß die Fremdstoffkonzentration in der mindestens einen Fremdstoffschicht (42) in solcher Weise an die Dicke der zweiten Verbindungshalbleiter-Schichten (41, 43) angepaßt ist, daß Tunnelströme durch den zweiten Halbleiterbereich (41, 42, 43) vermieden sind.

10. Verfahren nach Anspruch 9, bei dem die erste Halbleiterschicht (41) und die zweite Halbleiterschicht (43) durch Kristallwachstum hergestellt werden.

## Revendications

1. Dispositif à semiconducteurs comportant une première région semiconductrice composite (3) possédant une première constante de réseau, et une seconde région semiconductrice composite (41,42,43) située sur la première région semiconductrice composite (3) et possédant une seconde constante de réseau différente de la première constante de réseau;
la seconde région semiconductrice composite (41, 42,43) possédant au moins deux secondes couches semiconductrices composites (41,43), avec au moins une couche d'impuretés (42) disposée respectivement entre des secondes couches semiconductrices composites adjacentes (41,43) de la seconde région semiconductrice composite (41,42,43);
caractérisé en ce que :
les première et seconde constantes de réseau des première et seconde régions semiconductrices composites (3;41,42,43) diffèrent de telle sorte que leur désadaptation de réseau produit des réseaux de dislocation dans les secondes couches semiconductrices composites (41) voisines de la première région semiconductrice composite (3); en ce que la ou les couches d'impuretés (42) comportent des impuretés qui sont adsorbées ou dégazées sélectivement autour des dislocations et sont d'un type tel qu'elles neutralisent les charges résultantes des noyaux de dislocation; et en ce que la concentration en impuretés dans la ou les couches d'impuretés (42) est adaptée à l'épaisseur des secondes couches semiconductrices composites (41,43) de telle sorte que des courants d'effet tunnel à travers la seconde région semiconductrice (41,42,43) sont évités.

2. Dispositif à semiconducteurs selon la revendication 1, dans lequel les impuretés sont des donneurs.

3. Dispositif à semiconducteurs selon la revendication 1 ou 2, dans lequel la couche d'impuretés (42) contient du Si en tant qu'impureté.

4. Dispositif à semiconducteurs selon l'une quelconque des revendications précédentes, dans lequel la seconde couche semiconductrice composite (43) de la seconde région semiconductrice composite la plus éloignée du premier semiconducteur composite (3) possède une épaisseur non supérieure à 60 nm, et la ou chaque autre seconde couche semiconductrice composite possède une épaisseur comprise entre 5 et 30 nm.

5. Dispositif à semiconducteurs selon l'une quelconque des revendications précédentes, dans lequel la première région semiconductrice composite (3) est formée de (InGa)As.

6. Dispositif à semiconducteurs selon l'une quelconque des revendications précédentes, dans lequel la seconde région semiconductrice composite est formée de GaAs.

7. Dispositif à semiconducteurs selon l'une quelconque des revendications 1 à 5, dans lequel ladite seconde région semiconductrice composite est formée de Ga_{1-Z}Al_{Z}As (0 < Z ≤ 0,7).

8. Dispositif à semiconducteurs selon l'une quelconque des revendications 1 à 4, dans lequel la première région semiconductrice composite est un cristal mixte quaternaire exprimé par (In_{X}Ga_{1-X}) (As_{Y}P_{1-Y}) avec 0<X, Y<1; et le second semiconducteur composite est un cristal mixte tertiaire exprimé par Ga_{1-Z}Al_{Z}As avec 0<Z≤0,7.

9. Procédé de fabrication d'un dispositif à semiconducteurs consistant à former une première couche semiconductrice (41) sur une première région semiconductrice composite (3), qui possède une première constante de réseau, la première couche semiconductrice (41) étant formée d'un second semiconducteur composite possédant une seconde constante de réseau différente de la première constante de réseau; former au moins une couche d'impuretés (42) sur la première couche semiconductrice composite (41); et
former une seconde couche semiconductrice (43) du second semiconducteur composite sur la ou les couches d'impuretés (42);
caractérisé en ce que :
les première et seconde constantes de réseau diffèrent de telle sorte que leur désadaptation produit des réseaux de dislocation dans la première couche semiconductrice (4); et la ou les couches d'impuretés (42) comportent des impuretés qui sont adsorbées ou dégazées sélectivement autour des dislocations et sont d'un type tel qu'elles neutralisent les charges résultantes des noyaux de dislocation; et en ce que la concentration en impuretés dans la ou les couches d'impuretés (42) est adaptée à l'épaisseur des secondes couches semiconductrices composites (41,43) de telle sorte que des courants d'effet tunnel à travers la seconde région semiconductrice (41,42,43) sont évités.

10. Procédé selon la revendication 9, dans lequel la première couche semiconductrice (41) et la seconde couche semiconductrice (43) sont formées par croissance cristalline.
